(19) **Europäisches Patentamt / European Patent Office / Office européen des brevets**

(11) **EP 4 737 851 A1**

(12) # EUROPEAN PATENT APPLICATION

(43) Date of publication:
06.05.2026 Bulletin 2026/19

(21) Application number: 24210119.4

(22) Date of filing: 31.10.2024

(51) International Patent Classification (IPC):
$G01C\ 19/5776^{(2012.01)}$  $H03M\ 3/00^{(2006.01)}$

(52) Cooperative Patent Classification (CPC):
G01C 19/5776; H03M 3/30; H03M 3/458

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(71) Applicant: **Murata Manufacturing Co., Ltd.**
**Nagaokakyo-shi, Kyoto 617-8555 (JP)**

(72) Inventor: **AALTONEN, Lasse**
**02240 Espoo (FI)**

(74) Representative: **Boco IP Oy Ab**
**Kansakoulukatu 3**
**00100 Helsinki (FI)**

(54) **ANALOG DEMODULATION USING FULL-WAVE RECTIFICATION AND OVERSAMPLING ADC**

(57) The disclosure relates to a circuitry and a method for extracting a digitized DC voltage value representing a magnitude of a discrete-time signal received from a discrete-time system. A first full-wave rectifier performs a full-wave rectification of the discrete-time signal to obtain a full-wave rectified signal, and an oversampling analog-to-digital converter digitizes the full-wave rectified signal to obtain a bitstream. The oversampling ADC comprises a second-order or higher order delta-sigma modulator and a filter. The filter is configured to filter the bitstream to extract the digitized DC voltage value.

Figure 3

EP 4 737 851 A1

**Description**

FIELD OF THE DISCLOSURE

The present disclosure relates to a method and circuitries for analog demodulation, and particularly to method and circuitries for analog demodulation of discrete-time signals.

BACKGROUND OF THE DISCLOSURE

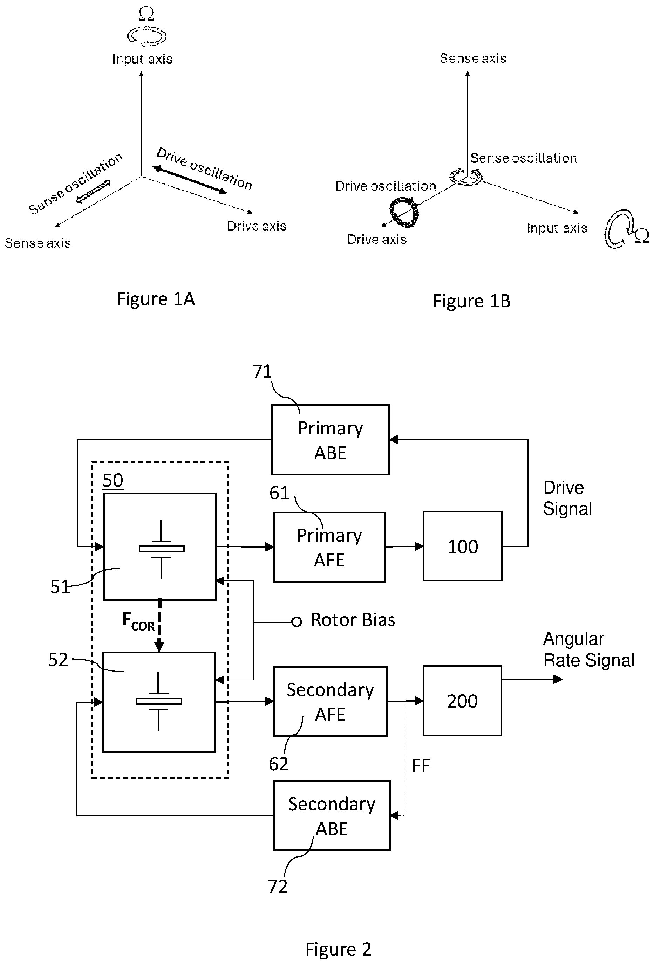

MEMS gyroscopes use the Coriolis effect to measure angular velocity. A mass element is driven into oscillating movement by an actuating drive force. This oscillation may be called "drive oscillation" or "primary oscillation", and it may be said that the mass element moves in a "primary oscillation mode". This movement can be either linear oscillation along a drive axis as illustrated in Figure 1A, or rotational oscillation about a drive axis as illustrated in Figure 1B.

The actuating force which maintains the drive oscillation can be generated, for example, by an electrostatic (capacitive) or piezoelectric actuator. The actuator may also be called a force transducer or an input transducer. The electrical signal which controls this actuator may be called a drive signal.

When the gyroscope containing the mass element in drive oscillation is subject to an angular rotation rate $\Omega$ about an input axis which is perpendicular to the drive axis, the mass element is driven into a second oscillation mode by the Coriolis force. This oscillation may be called "sense oscillation" or "secondary oscillation", and it may be said that the mass element moves in a "secondary oscillation mode".

This sense oscillation can be either linear oscillation along a sense axis, or rotational oscillation about a sense axis. The sense axis may also be referred to as a secondary axis or as a detection axis, and the sense oscillation may also be referred to as a secondary oscillation or as a detection oscillation. If the primary oscillation is linear, the Coriolis force driven sense oscillation is typically linear but may alternatively be coupled to be rotational. If the primary oscillation is rotational, then the Coriolis force driven sense oscillation is typically rotational but may alternatively be coupled to be linear.

MEMS vibratory gyroscopes have typically one drive axis on or about which the mass element called drive resonator, also referred to as a proof mass, oscillates. A large mechanical oscillation amplitude of the drive resonator is important to maximize the Coriolis signal. Coriolis force appears when an inertial reference frame of the oscillating MEMS vibratory gyroscope and its drive resonator is rotated about the input axis that is orthogonal to the drive axis. Rotation couples the drive oscillation in the direction of the sense axis, that is orthogonal to both the drive axis and the input axis. Coriolis force $F_{COR}$ is caused according to formula:

$$F_{COR} = 2 * \Omega v_{DRV} * m_{DRV},$$

where $\Omega$ is the rotation rate about the input axis, and $v_{DRV}$ is the velocity and $m_{DRV}$ is the mass of the drive resonator.

Figure 2 illustrates a high level schematic of an exemplary vibratory MEMS gyroscope. An electro-mechanical MEMS resonator 50 may be characterized by the two main motions: primary and secondary motion. The MEMS resonator 50 may comprise a single moving MEMS mass in a single MEMS element capable for both primary and secondary motions, or it may comprise two or more MEMS elements and moving masses.

For simplicity, figure 2 illustrates a resonator with two MEMS elements, a drive resonator 51 and a sense resonator 52, the latter of which may also be called as a detection element or a sensing element. At least one primary mass of the drive resonator 51 is driven into the drive oscillation with a closed primary drive loop, which includes a primary analog front end circuitry (primary AFE) 61, a primary loop circuitry 100 and a primary analog back end circuitry (primary ABE) 71. The primary loop circuitry 100 may be analog or digital. The Coriolis force $F_{COR}$ due to angular velocity $\Omega$ effecting the primary mass(es) causes secondary, detection movement of at least one secondary mass of the secondary element. As known in the art, detection movement of the at least one secondary mass may be mechanically coupled from the at least one primary resonator in various ways, so that the detection movement of the secondary mass to be similar to or different from the Coriolis force driven sense oscillation. A linear sense oscillation may be conveyed into a linear detection movement or into a rotational detection movement. A rotational detection oscillation may be conveyed into a rotational detection movement or into a linear detection movement.

The movement of the secondary mass(es) of the secondary element is detected by a detection circuitry, which in this non-limiting example includes a secondary analog front end circuitry (secondary AFE) 62, a secondary loop circuitry 200 and optionally a secondary analog back end circuitry (secondary ABE) 63. The detection circuitry produces an "Angular Velocity Out" signal indicating amount of angular velocity $\Omega$ about the input axis detected by the vibratory MEMS gyroscope. In a simplified implementation, the Angular Velocity Out signal, which may be referred in short as angular rate signal or rate signal, could also be obtained directly at the output of the secondary AFE 62. The detection circuitry may include a force feedback loop, in which case the secondary analog back end circuitry ABE 72 is utilized for feeding a force feedback signal (FF) back to the sense resonator 52. The secondary loop circuitry 200 may be analog or digital. The secondary AFE 62 receives a continuous-time Coriolis signal of the sense resonator 52 and produces a discrete-time output signal by sampling the continuous-time Coriolis signal of the sense resonator. The force feedback signal (FF), if applied, is preferably generated based on the signal received from the secondary AFE 62.

The sense resonator 52 is ideally sensitive only in the direction of the sense axis that is perfectly orthogonal to both the drive axis and the input axis. Now, assuming drive resonator 51 is a harmonic oscillator, the velocity magnitude | $v_{DRV}$| of the drive resonator 51 is:

$$|\boldsymbol{v}_{DRV}| = v_{DRV_{amp}} * \sin\left(2\pi f_{DRV} t\right)$$

where $v_{DRV_{amp}}$ is the amplitude of velocity, and $f_{DRV}$ is the drive frequency, in other words the frequency of the drive oscillation. Rotation rate $\Omega$ is a time dependent variable and drive motion is turning the Coriolis force $F_{COR}$ into an amplitude modulated force, that must be demodulated before an output signal referred here as Angular Velocity Out, can be obtained that is directly proportional to the rotation rate $\Omega$.

Demodulation can be done in many ways. A Gilbert cell is a traditional alternative but rarely applicable in MEMS sensor where signals are maximized and have relatively low frequencies, typically in range of tens of kHz. Another alternative is to use a digital sin*sin multiplier on a digitized sense resonator output signal and high accuracy digital sine. However, the digital multiplier, even though accurate, is typically a power-hungry method of demodulation. This is because digitizing an accurate drive frequency Coriolis signal requires a fast analog-to-digital converter (ADC).

In analog domain, a full-wave rectifier is a simple method of demodulation, but often considered problematic due to heavy harmonic signal content. It is susceptible to folding but offers by nature $f_{DRV}/f_{HARM}$ (=$\omega_{DRV}/\omega_{HARM}$) attenuation at odd harmonic frequencies $f_{HARM}$ of the drive frequency $f_{DRV}$. For example, at the third harmonic, the lowest frequency that is demodulated to a DC voltage, the magnitude after full-wave rectifier is 1/3 compared with the full-wave rectified DC voltage value. Thus, full-wave rectifier is three times better in terms of folding compared to direct down-sampling of the Coriolis signal.

BRIEF DESCRIPTION OF THE DISCLOSURE

An object of the present disclosure is to obtain a digitized DC voltage value of a rectified discrete-time signal received from the discrete-time system. When the discrete-time signal is received from an output transducer vibratory MEMS gyroscope, the discrete-time signal is obtained by sampling an essentially continuous-time Coriolis signal. Most common examples of the discrete-time signal in a vibratory MEMS gyroscope are a sense signal from an output transducer in an open-loop rate sensing loop of the vibratory MEMS gyroscope, and a sense signal from an output transducer in a closed force feedback loop of the vibratory MEMS gyroscope. The output transducer obtains samples of the continuous-time Coriolis signal and outputs the discrete-time signal. In a capacitive vibratory MEMS gyroscope, the output transducer typically performs a charge to voltage conversion, so that the discrete-time signal is an amplitude modulated AC voltage signal.

The object is achieved by further applying a demodulation circuitry that utilizes an oversampling ADC to obtain a digitized DC value of the full-wave rectified discrete-time signal with minimum complexity of the electronic circuitry needed to accomplish desired results. The oversampling ADC is configured to directly digitize the discrete-time signal after it has been rectified by a full-wave rectifier.

The full-wave rectifier is preferably a simple set of switches changing the polarity of the incoming discrete-time signal at a demodulation frequency CK_DEMOD, which has the same frequency in comparison to the drive frequency $f_{DRV}$. According to embodiments, the oversampling ADC comprises a filter after the modulator to remove high frequency quantization noise. Decimation is a typically added operation in filtering when time resolution of output signal can be much coarser than that of ADC input. A separate decimation filter may be provided after the oversampling ADC. The decimation filter removes also the harmonics fed to the oversampling ADC after the full-wave rectification. After a continuous time, full-wave rectification of a time continuous sine (assuming $\Omega$ is a nonzero signal) the harmonic series can be written as

$$f(t) = \frac{2V_{amp}}{\pi} + \frac{4V_{amp}}{\pi} \sum_{n=1}^{\infty} \frac{1}{4*n^2-1} \cos\left(2n\omega_{DRV} t\right)$$

For a sine signal with amplitude $V_{amp}$ and *frequency* $\omega_{DRV} = 2\pi f_{DRV}$.

According to a first aspect, a circuitry for extracting a digitized DC voltage value representing a magnitude of a discrete-time signal received from a discrete-time system is provided. The circuitry comprises a first full-wave rectifier configured to perform a full-wave rectification of the discrete-time signal to obtain a full-wave rectified signal. The circuitry comprises an oversampling analog-to-digital converter, ADC, configured to digitize the full-wave rectified signal to obtain a bitstream. The oversampling ADC comprises a second-order or higher order delta-sigma modulator and a filter. The filter is configured to filter the bitstream to extract the digitized DC voltage value.

According to some embodiments, the circuitry further comprises a switched capacitor amplifier configured to amplify the discrete-time signal, or the circuitry further comprises a high-pass filter with a switched capacitor feedback configured to amplify the discrete-time signal.

According to some embodiments, the circuitry further comprises a second full-wave rectifier configured to perform a second full-wave rectification of the discrete-time signal to obtain a full-wave rectified quadrature signal, and a quadrature circuitry. The quadrature circuitry comprises a second oversampling analog-to-digital converter, ADC, configured to digitize the full-wave rectified quadrature signal to obtain digital quadrature signal data, or the quadrature circuitry comprises a switched-capacitor stage configured to obtain samples of the full-wave rectified quadrature signal to obtain an analog quadrature signal.

According to some embodiments the digital quadrature signal data or the analog quadrature signal is configured to be used for at least one of cancelling of quadrature errors from an angular rate signal, electrostatic quadrature compensation, and monitoring functional safety capable sensor.

According to some embodiments, the discrete-time signal is an amplitude-modulated AC voltage signal with a carrier frequency, and an output transducer of the discrete-time system producing the discrete-time signal, and the oversampling ADC are operated with the same sample rate. A ratio R between frequencies of the sample rate and the carrier frequency is any one of: 8, 6, 32, and 64.

According to some embodiments, the filter is a decimation filter and a decimation ratio applied by the decimation filter is at least equal to the ratio R.

According to some embodiments, an oversampling ratio OSR is a ratio of digital data rate after decimation filtering by the decimation filter and the sample rate, and a ratio OSR/R is 2X where x is an integer at least -1, preferably at least 0, and most preferably at least 1.

According to some embodiments, the discrete-time system is a sense resonator of a vibratory MEMS gyroscope with an/the output transducer configured to obtain discrete-time samples to generate the discrete-time signal. The discrete-time signal represents a position of a sense mass of the sense resonator in an open sense loop of the vibratory MEMS gyroscope.

According to some embodiments, the discrete-time signal is generated by sampling, by the output transducer, a Coriolis signal of the sense resonator of the vibratory MEMS gyroscope.

According to some embodiments, the discrete-time signal represents the position of the sense mass of the sense resonator in a closed force feedback loop of the vibratory MEMS gyroscope. The force feedback loop comprises a force feedback circuitry configured to generate a force feedback signal based on the discrete-time signal.

According to a second aspect, method for extracting a digitized DC voltage value representing a magnitude of a discrete-time signal received from a discrete-time system is provided. The method comprises performing a first full-wave rectification to the discrete-time signal to obtain a full-wave rectified signal, digitizing the full-wave rectified signal by an oversampling analog-to-digital converter, ADC, comprising a second-order or higher order delta-sigma modulator, to obtain a bitstream, and filtering the bitstream by a filter configured to extract the digitized DC voltage value.

According to some embodiments, the method further comprises amplifying the discrete-time signal by a switched capacitor amplifier or amplifying the discrete-time signal by a high-pass filter with a switched capacitor feedback.

According to some embodiments, the method further comprises performing a second full-wave rectification of the discrete-time signal by a second full-wave rectifier to obtain a full-wave rectified quadrature signal, and performing a second digitizing of the full-wave rectified quadrature signal by a second oversampling ADC to obtain digital quadrature signal data, or the method further comprises obtaining samples of the full-wave rectified quadrature signal by a switched capacitor stage to obtain an analog quadrature signal.

According to some embodiments, the method comprises using the digital quadrature signal data or the analog quadrature signal for at least one of cancelling of quadrature errors from an angular rate signal, electrostatic quadrature compensation, and monitoring functional safety capable sensor.

According to some embodiments, the discrete-time signal is an amplitude-modulated AC voltage signal with a carrier frequency. The method comprises operating an output transducer of the discrete-time system for producing the discrete-time signal, and the oversampling ADC with the same sample rate. A ratio R between frequencies of the sample rate and the carrier frequency is any one of: 8, 6, 32, and 64.

According to some embodiments, the filter is a decimation filter, and a decimation ratio applied by the decimation filter is at least equal to the ratio R.

According to some embodiments, an oversampling ratio OSR is a ratio of digital data rate after decimation filtering by the decimation filter and the sample rate, and a ratio OSR/R is 2X where x is an integer at least -1, preferably at least 0, and most preferably at least 1.

According to some embodiments, the discrete-time system is a sense resonator of a vibratory MEMS gyroscope with the output transducer, and the discrete-time signal represents a position of a sense mass of the sense resonator in an open sense loop of the vibratory MEMS gyroscope.

According to some embodiments, the method comprises generating the discrete-time signal by sampling, by the output transducer, a Coriolis signal of the sense resonator of the vibratory MEMS gyroscope.

According to some embodiments, the discrete-time signal represents the position of the sense mass of the sense resonator in a closed force feedback loop of the vibratory MEMS gyroscope, wherein the method comprises generating, by a force feedback circuitry, a force feedback signal based on the discrete-time signal.

Key benefits of invention are that complexity of the circuitry is minimized and area and supply current needed for digitizing the discrete-time signal 20 are efficiently minimized. The circuitry may be further tuned to emphasize high noise performance by increasing data rate and power consumption. The circuitry may alternatively be tuned to emphasize low current consumption by decreasing sample rate.

The object of the disclosure is achieved by a circuitry and a method which are characterized by what is stated in the independent claims. Some embodiments of the disclosure are disclosed in the dependent claims.

The disclosure is based on the idea of full-wave rectification of the discrete-time signal and digitizing it with an oversampling analog-to-digital converter.

An advantage of the circuitry and method of the disclosure is that circuitry area and supply current needed to implement digitizing of the discrete-time signal can be minimized. The design can be tuned to emphasize either high noise performance by increasing data rate and power consumption, or low current by decreasing sample rate.

BRIEF DESCRIPTION OF THE DRAWINGS

In the following the disclosure will be described in greater detail by means of preferred embodiments with reference to the accompanying drawings, in which:

Figures 1A and 1B illustrate oscillations and axes of vibratory MEMS gyroscopes.

Figure 2 illustrates a high level schematic of an exemplary vibratory MEMS gyroscope.

Figure 3 illustrates a circuitry according to a first embodiment.

Figure 4A illustrates a discrete-time signal.

Figure 4B illustrates a full-wave rectified discrete-time signal.

Figure 4C illustrates a digitized and filtered and decimated signal with DC values representing samples of the discrete-time signal.

Figure 5 illustrates harmonic frequencies of the discrete-time signal.

Figure 6 illustrates a circuitry according to a second embodiment.

Figures 7A and 7B illustrate mutual timings of clocks.

Figure 8 illustrates a circuitry according to a third embodiment.

Figure 9 illustrates a circuitry according to a fourth embodiment.

DETAILED DESCRIPTION OF THE DISCLOSURE

The disclosure relates to a circuitry and a method for digitizing a discrete-time signal.

As used in this application, term "circuitry" refers to all of the following: (a) hardware-only circuit implementations and (b) combinations of circuits and software (and/or firmware), such as (i) to a combination of processor(s) or (ii) to portions of processor(s)/software (including digital signal processor(s), software and memory(ies) that work together to cause an apparatus to perform various functions and (c) to circuits, such as microprocessor(s) or a portion of a microprocessor(s) that require software or firmware for operation, even if the software or firmware is not physically present. Hardware of a circuit implementation may include any and all of application specific circuit(s) (ASIC) or general configurable circuitry such as field programmable gate array(s) (FPGA), or like.

In this context, "a digitized DC value" refer to a DC voltage that has a limited number of possible voltage levels.

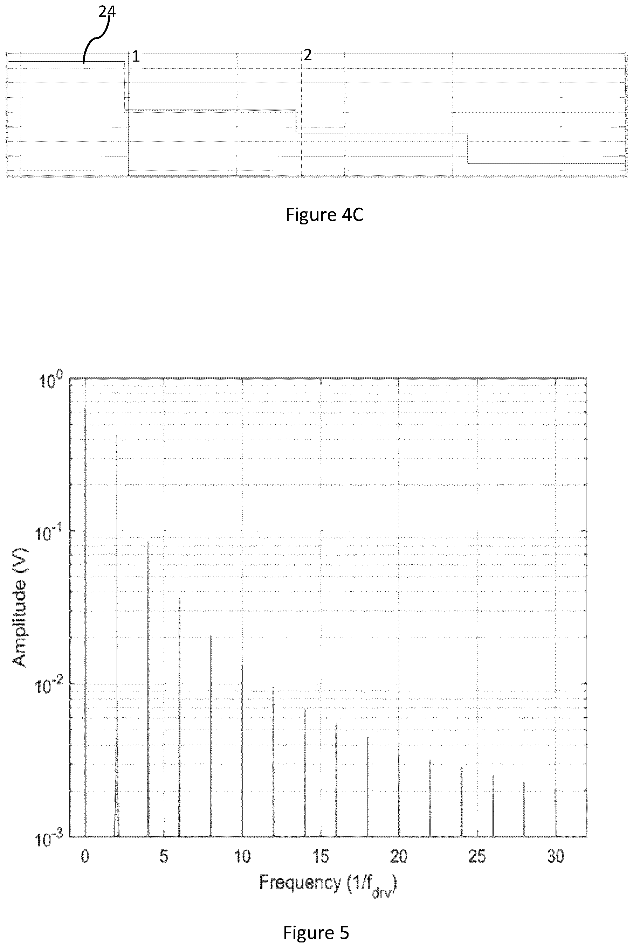

Output of the oversampling ADC is a digital signal comprising logic "1"s and "0"s, which may be decimated and filtered for generating the digitized DC value. An example of a signal comprising digitized DC values is illustrated in Figure 4C.

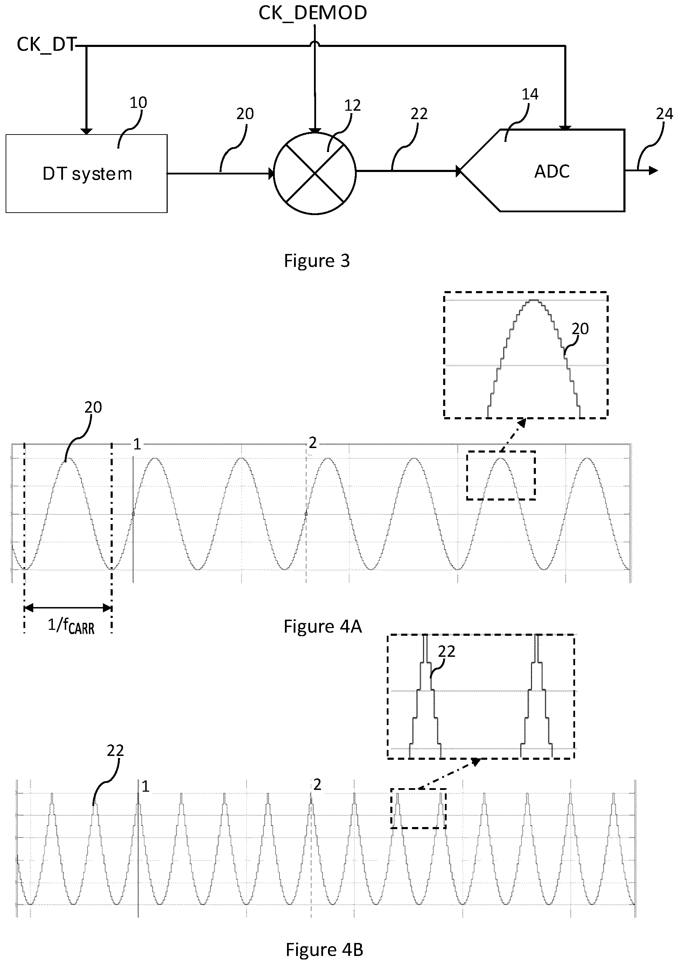

Figure 3 illustrates a circuitry according to a first embodiment.

In the disclosed embodiments, the discrete-time system 10 refers to a vibratory MEMS gyroscope and the secondary AFE 62 shown in the figure 2, that outputs a discrete-time signal 20. The vibratory MEMS gyroscope converts Coriolis force -driven sense oscillation into a Coriolis motion of the sense resonator, which is sampled by an output transducer to obtain the discrete-time signal 20. The discrete-time signal 20 is characterized by properties such as linearity, time invariance, stability, and causality, similar to properties of continuous-time systems. An example of applicable discrete-time system comprises the sense resonator of the vibratory MEMS gyroscope, and the discrete-time signal is the output signal that is based on sampling a continuous-time signal, namely the Coriolis signal of the sense resonator. Sampling of the continuous-time signal is performed by an output transducer of the sense resonator. Input signal (not shown) for the discrete-time system is the Coriolis motion of a sense resonator of the vibratory MEMS gyroscope. Output signal from the output transducer of the sense resonator is a discrete-time, amplitude modulated AC voltage signal that represents detected position of the sense resonator as a function of time. When position of the sense resonator is detected capacitively, and a charge-to-voltage conversion is performed by means of the output transducer, typically comprising a switched capacitor (SC) circuitry. According to some embodiments, the sampling SC circuitry may comprise a charge sensitive amplifier (CSA) where only the DC-feedback is a switched-capacitor circuit. An example of a known time-continuous CSA readout circuitry is disclosed in "Fully integrated charge sensitive amplifier for readout of micromechanical capacitive sensors" by M. Saukoski; L. Aaltonen; K. Halonen; T. Salo in 2005 IEEE International Symposium on Circuits and Systems (ISCAS). This facilitates large polysilicon resistor for handling of DC bias voltage that is fed into the at least one secondary mass to enable capacitive readout. The resistor equivalent circuit can be replaced by a switched capacitor equivalent circuit. Such output transducer with switched-capacitor DC feedback can be considered as a hybrid system, since it provides a discrete-time signal that appears almost like a continuous time signal but is easy to sample because the SC feedback loop determines applicable sampling rates.

Another example of a discrete-time system is a part of the force feedback loop in a MEMS gyroscope. As known in the art, and illustrated in the figure 2, the force feedback loop is a closed loop feeding the force feedback signal FF as a force back to the sense resonator to improve bandwidth, drift and other sensor characteristics. The force feedback signal is determined based on the same discrete-time signal as the rate signal, obtained by sampling the same Coriolis signal from the sense resonator of the MEMS gyroscope. Implementing a force feedback loop in a MEMS gyroscope is optional.

Let's assume that a discrete-time, amplitude modulated signal (AM signal), referred herein as the discrete-time signal 20, is coming directly from the discrete-time system, DT system 10. This corresponds output signal of the secondary AFE 62 in the figure 2. The circuitry utilizes two different clocks signals: a sample clock CK_DT and a demodulation clock CK_DEMOD. These clock signals CK_DEMOD and CK_DT as well as an AC drive signal for driving the drive oscillation, also referred to as a carrier signal, are mutually synchronized in time domain. The AC drive signal drives the primary resonator at a drive frequency, also called herein as a carrier frequency. The discrete-time signal 20 is demodulated by the full-wave rectifier 12 and the full-wave rectified signal 22 is converted by an oversampling analog-to-digital converter ADC 14. Type of the oversampling ADC 14 is preferably a second-order delta-sigma modulator, which is simplest well performing modulator. A higher than second order, a.k.a. higher-order delta-sigma modulator is also applicable, although more complex, requiring greater circuit area and having higher power consumption. Exemplary simulated signals of the circuitry of Figure 3 are illustrated in Figures 4A to 4C, all showing voltage as a function of time. Labels 1 and 2 in Figures 4A to 4C mark corresponding instances of time. Figure 4A illustrates the AC, discrete-time signal 20 of the discrete-time system. The enlarged portion shows more clearly the discrete-time nature of the discrete-time signal 20, comprising samples of the Coriolis signal, wherein length of the time period covered by each sample is determined by a sample clock CK_DT.

Figure 4B illustrates the demodulated, full-wave rectified signal 22. The enlarged portion of Figure 4B shows more clearly the discrete-time nature of the full-wave rectified signal 22.

Figure 4C illustrates extracted digitized DC values of the output signal 24 after an analog-to-digital conversion and filtering. Filter is settling to emphasize the time instants when digital value is changing. The filter may be a decimation filter. An exemplary decimation filter is a cascaded-integrator-comb, CIC filter.

Other possibilities for the implementing filtering after analog-to-digital conversion are a low-pass finite input response (FIR) filter or a low-pass infinite input response (IIR) filter, in which cases decimation may be performed after filtering. The output signal 24 may be the rate signal, or the output signal 24 may be further processed to obtain the rate signal. A force feedback loop is optional. The force feedback loop is preferably generated based on the discrete-time signal 20, since this avoids any adverse effects of digitizing and/or digital filtering in the force feedback loop and thus provides the best dynamic performance for the force feedback loop. Methods for generating the force feedback signal are known to a person skilled in the art and not part of this disclosure.

In the displayed example of figures 4A to 4C, a ratio R, which is defined as the ratio between a sample rate (frequency) $f_{CK\_DT}$ of a sample clock CK_DT used by for clocking the output transducer of the discrete-time system and the oversampling ADC 14, and the carrier frequency $f_{CARR}$ of the discrete-time signal 20 is R= $f_{CK\_DT}$ /$f_{CARR}$=64, the sample rate being thus 64 times the carrier frequency. The ratio R is an important design parameter, the selection of which depends on noise performance, absolute frequencies of the carrier, and power consumption. In a micro vibratory MEMS gyroscope's interfaces ratios R=8, R=16, R=32, R=64, and R=128 are applicable. The lower the ratio R, the lower power the oversampling ADC and the system is, and the higher the ratio R, the lower the thermal noise spectral content is. Low sample rate makes also the system prone to folding of high frequency parasitic signals. The ratio R in 2's power is preferred since this reduces the complexity of clock generation. Note that the ratio R is not necessarily equal to the decimation ratio applied by the decimation filter, but it is feasible to set the decimation ratio at least equal to the ratio R.

Figure 5 illustrates how harmonic series of full-wave rectified sine in discrete-time setup becomes limited. Numbers of harmonics are depicted at the horizontal scale. Discrete-time setup can carry frequency information only up to Nyquist frequency and therefore the harmonic series can be now written as

$$f(t) = \frac{2V_{amp}}{\pi} + \frac{4V_{amp}}{\pi} \sum_{n=1}^{\frac{R}{2}} \frac{1}{4*n^2 - 1} \cos(2n\omega_{DRV}t)$$

A one-sided spectrum of an example simulation system is shown in Figure 5, showing harmonics of the full-wave rectified signal 22. Initially all harmonics, in the example up to 32 (Nyquist frequency is R/2), are initially digitized by the oversampling ADC, but mixed with quantization noise and eventually removed by the decimation filter when the oversampling ratio, OSR, is higher than the ratio R. The oversampling ratio OSR is here defined as the ratio of the digital data rate after decimation filtering and the sample rate of the sample clock CK_DT, applied by the oversampling ADC. The ratio of OSR/R is preferably $2^X$ where x is a positive integer or zero. When OSR/R=1, x being 0, the decimation will remove also up-converted offset and flicker noise. It is even possible to use OSR/R = 0.5, equaling having x=-1, in which case digital data rate must be high, but in this case, it is beneficial to add filtering to remove the additional ripple due to up-converted parasitic signals.

It is known that when the oversampling ratio OSR is small the quantization noise will dominate the output noise, and therefore a practical oversampling ratio OSR is from 16 up to $2^{10}$ depending on whether high output data rate is preferred over high accuracy. In the example system used for simulation, the oversampling ratio OSR is 128, i.e. when the ratio R is 64, the digital data is updated every two periods of sine as the cursors 1 and 2 in the figures 4A to 4C indicate.

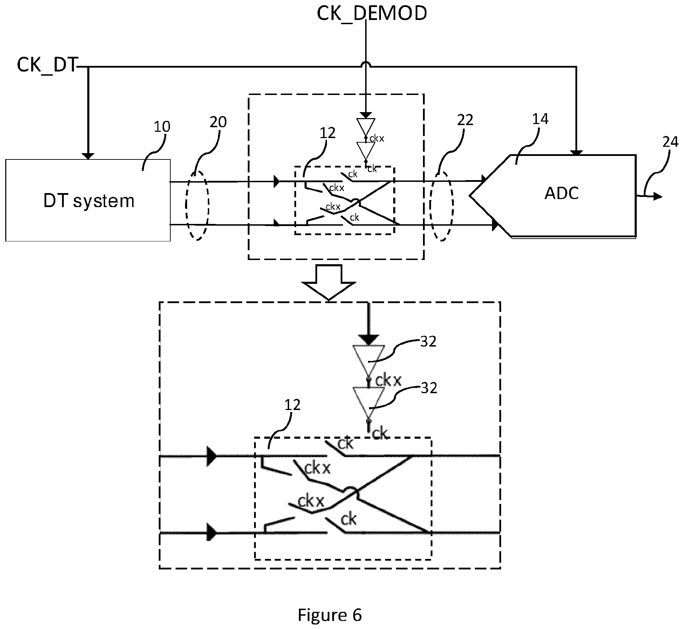

A more detailed implementation of the circuitry with the full-wave rectifier 12 is shown in the Figure 6. An enlarged view of the full-wave rectifier 12 is shown under the overall schematic for clarity. The full-wave rectifier 12 does not require fully non-overlapping demodulation clock signals *ck* and *ckx* in case the discrete-time system 10 driving the full-wave rectifier 12 can tolerate a very short periods of short circuit. This is different from e.g. sampling operation by a switched capacitor circuit, where even sub nanosecond short circuit may deteriorate signal quality. Inverters 32 may be sufficient for generating two mutually opposite-phase demodulation clock signals *ck* and *ckx.* A very short period refers here to durations less than a nanosecond. Thus, clock signal generation can be kept simple. A short overload-based glitch caused by simultaneously switching *ck* and *ckx* does not cause error in the driving stage, since any remining charge is zeroed by the next sample time.

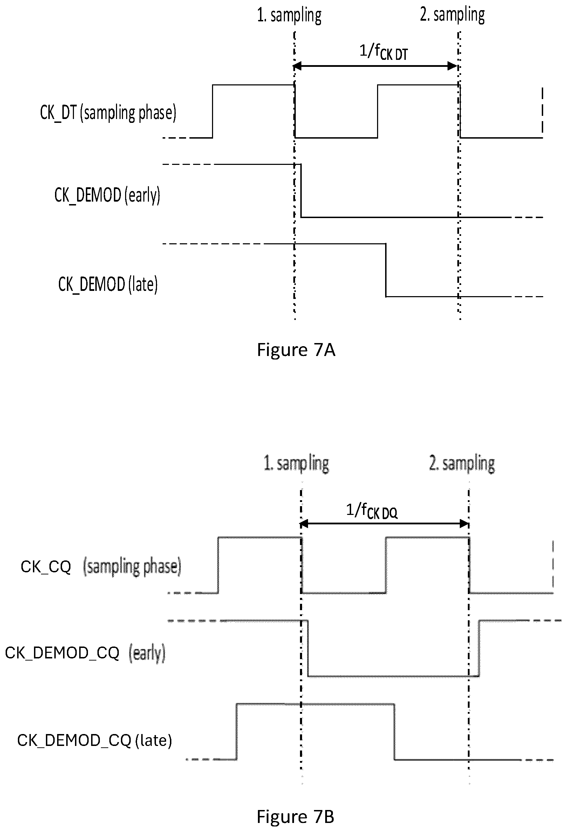

It is important to design how the demodulation clock CK_DEMOD used by the full-wave rectifier is timed with respect to discrete-time operation. The clock signal examples in the Figure 7A show two typical timing examples for demodulation. The sample clock CK_DT is used for sampling by the switched-capacitor (SC) transducer of the discrete-time system as well as for sampling by the oversampling ADC. The demodulation clock CK_DEMOD state change high-to-low is preferably taking place just after previous sampling instant (early) or latest just after the start of sampling period (late). It is assumed that low-to-high change is similarly timed but exactly half a demodulation clock CK_DEMOD period later. Important is that neither ADC driving, nor the sampling of ADC, are disturbed by the change of state of the demodulation clock CK_DEMOD.

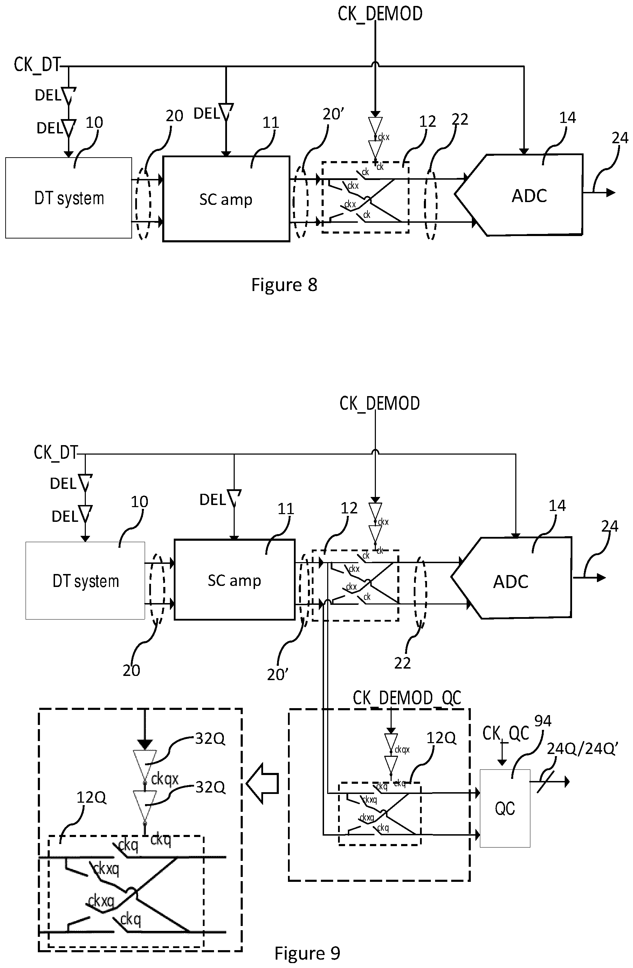

The only clear drawback of feeding the full-wave rectified signal 22 to the oversampling ADC 14 is that the DC value of the sine-formed full-wave rectified signal 22 is $2/\pi$ times the input amplitude of the original discrete-time signal 20, which requires 1/0.637 additional headroom in the oversampling ADC 14. However, this is usually a minor drawback, since a digital sine multiplier base demodulation requires even higher additional headroom. In fact, it may be that the required sensor output dynamic range is smaller than that discrete-time system dynamic range. For example, to ensure rapid recovery after overrange, the discrete-time system 10 dynamic range must be higher, but the oversampling ADC 14 doesn't require the full dynamic range. In this case a simple buffer, i.e. a switched-capacitor (SC) amplifier, can be added before the oversampling ADC as shown in the figure 8, illustrating a second embodiment. The benefit of this may also be that, when the oversampling ADC 14 has significant contribution in noise, adding gain of e.g. 2 or 4 before the oversampling ADC 14 will reduce the oversampling ADC's 14 effective noise equally.

In the embodiment shown in the Figure 8, one or more delay cells (DEL) are added to the sample clock CK_DT when used for controlling switched capacitors of the switched-capacitor output transducer of the DT system 10 as well as when used for controlling the switched capacitor (SC) amplifier 11, to control mutual timing relations. Delay cells (DEL) may enhance the precision when the oversampling ADC 14 is the first point which performs sampling. For example, the SC amplifier 11 can also be simple high-pass filter with SC DC feedback.

The SC amplifier 11 amplifies the discrete-time signal 20 to generate an amplified discrete-time signal 20'. This alternative offers best noise performance, and the feedback should in this case be always updated after ADC 14 has sampled the signal. Delay by a single delay cell DEL is typically from few 100ps to few ns. The full-wave rectifier 12 is similar to what is illustrated in figure 6.

According to a third embodiment, a quadrature signal is accessed as illustrated in the Figure 9. The quadrature signal is typically the largest parasitic signal originating from primary oscillation, directly coupling to secondary signals, before the full-wave rectifier 12. The full-wave rectifier 12Q in the quadrature path is identical to the full-wave rectifier 12 of the in-phase path, and clock signals *ckq* and *ckxq* are generated in the similar manner as clock signals *ck* and *ckx* using inverters 32Q. This implies that when the quadrature circuitry 94 is digital, it also comprises an oversampling ADC to remove the harmonics and digitize the data. In this case the quadrature sample clock CK_QC would be the same as the sample clock CK_DT. The quadrature circuitry 94 extracts information on level of a quadrature signal received from the discrete-time system.

The digital quadrature signal data 24Q can be used for example a) for digital cancelling of quadrature errors from the digital rate signal, in other words from digitized Coriolis data, or b) for electrostatic quadrature compensation via digital-to-analog conversion, and/or c) for monitoring purposes in a functional safety capable sensor. In digital quadrature circuitry, a digital integrator may be used for filtering instead of a decimating filter.

Quadrature circuitry 94 may also be analog. In this case, the quadrature circuitry 94 may comprise a switched-capacitor stage configured to obtain samples of the full-wave rectified quadrature signal to obtain an analog quadrature signal 24Q'.

The analog quadrature signal 24Q' may be used a) for cancelling of quadrature errors from the angular rate signal, b) for electrostatic quadrature compensation, and/or c) for monitoring purposes in a functional safety capable sensor. Alternative methods for handling quadrature error in a MEMS gyroscope based on the digital quadrature signal data 24Q or the analog quadrature signal 24Q' are known to a skilled person.

In comparison to the general structure of a MEMS gyroscope shown in the figure 2, the optional SC amplifier 11 and/or the full-wave rectifier 12 may be considered as being part of the secondary AFE 62, and the oversampling ADC 14 may be considered either as part of the secondary AFE 62 or as part of the secondary loop circuitry 200. The sense resonator 52 may comprise the output transducer of the secondary loop, or the output transducer may be part of the secondary AFE 62. The discrete-time signal 20 or the amplified discrete-time signal 20' may be used as basis for generating the force feedback signal (FF), while the original discrete-time signal 20 is preferred.

Most area efficient quadrature compensation implementation is a fully analog one, in which the quadrature circuitry 94 is implemented as a switched-capacitor stage with a quadrature sampling clock, CK_QC, operating at a frequency of the demodulation clock CK_DEMOD and/or a quadrature demodulation clock CK_DEMOD_QC or at max twice of that, as illustrated in Figure 7B. Phase difference between the quadrature demodulation clock CK_DEMOD_QC and the demodulation clock CD_DEMOD is 90 degrees, but otherwise the operation principle and timing is similar to demodulation in the secondary loop. Sampling of the demodulated quadrature signal by the quadrature sampling clock CK_QC, phase would ideally coincide with the CK_DEMOD transitions, so that the quadrature signal, with a 90-degree shifted phase compared to Coriolis signal, is at maximum value at the sampling point. The sampled DC value (always sampling the same peak value) can then be directly used in e.g. proportional control or integrator to implement electrostatic quadrature compensation output.

Digital or analog quadrature control and/or compensation is also applicable in the first and second embodiments.

**Claims**

1. A circuitry for extracting a digitized DC voltage value representing a magnitude of a discrete-time signal received from a discrete-time system, **characterized in that** the circuitry comprises:

   - a first full-wave rectifier configured to perform a full-wave rectification of the discrete-time signal to obtain a full-wave rectified signal,
   - an oversampling analog-to-digital converter, ADC, configured to digitize the full-wave rectified signal to obtain a bitstream, wherein the oversampling ADC comprises a second-order or higher order delta-sigma modulator and a filter, and wherein the filter is configured to filter the bitstream to extract the digitized DC voltage value.

2. The circuitry according to claim 1, further comprising:

   - a switched capacitor amplifier configured to amplify the discrete-time signal, or
   - a high-pass filter with a switched capacitor feedback configured to amplify the discrete-time signal.

3. The circuitry according to claim 1 or 2, further comprising:

   - a second full-wave rectifier configured to perform a second full-wave rectification of the discrete-time signal to obtain a full-wave rectified quadrature signal, and
   - a quadrature circuitry comprising:

     - a second oversampling analog-to-digital converter, ADC, configured to digitize the full-wave rectified quadrature signal to obtain digital quadrature signal data, or
     - a switched-capacitor stage configured to obtain samples of the full-wave rectified quadrature signal to obtain an analog quadrature signal.

4. The circuitry according to claim 3, wherein the digital quadrature signal data or the analog quadrature signal is configured to be used for at least one of:

   - cancelling of quadrature errors from an angular rate signal,
   - electrostatic quadrature compensation, and
   - monitoring functional safety capable sensor.

5. The circuitry according to any one of claims 1 to 4, wherein

   - the discrete-time signal is an amplitude-modulated AC voltage signal with a carrier frequency, and
   - an output transducer of the discrete-time system producing the discrete-time signal, and the oversampling ADC are operated with the same sample rate, and
   - a ratio R between frequencies of the sample rate and the carrier frequency is any one of: 8, 6, 32, and 64.

6. The circuitry according to claim 5, wherein the filter is a decimation filter and a decimation ratio applied by the decimation filter is at least equal to the ratio R.

7. The circuitry according to claim 5 or 6, wherein an oversampling ratio OSR is a ratio of digital data rate after decimation filtering by the decimation filter and the sample rate, and a ratio OSR/R is $2^X$ where x is an integer at least -1, preferably at least 0, and most preferably at least 1.

8. The circuitry according to any one of claims 1 to 7, wherein the discrete-time system is a sense resonator of a vibratory MEMS gyroscope with an/the output transducer configured to obtain discrete-time samples to generate the discrete-time signal, and wherein the discrete-time signal represents a position of a sense mass of the sense resonator in an open sense loop of the vibratory MEMS gyroscope.

9. The circuitry according to claim 8, wherein the discrete-time signal is generated by sampling, by the output transducer, a Coriolis signal of the sense resonator of the vibratory MEMS gyroscope.

10. The circuitry according to claim 8 or 9, wherein the discrete-time signal represents the position of the sense mass of the sense resonator in a closed force feedback loop of the vibratory MEMS gyroscope, and wherein the force feedback loop comprises a force feedback circuitry configured to generate a force feedback signal based on the discrete-time signal.

11. A method for extracting a digitized DC voltage value representing a magnitude of a discrete-time signal received from a discrete-time system, **characterized in that** the method comprises:

    - performing a first full-wave rectification to the discrete-time signal to obtain a full-wave rectified signal,
    - digitizing the full-wave rectified signal by an oversampling analog-to-digital converter, ADC, comprising a second-order or higher order delta-sigma modulator, to obtain a bitstream, and
    - filtering the bitstream by a filter configured to extract the digitized DC voltage value.

**12.** The method according to claim 11, further comprising:

- amplifying the discrete-time signal by a switched capacitor amplifier, or
- amplifying the discrete-time signal by a high-pass filter with a switched capacitor feedback.

**13.** The method according to claim 11 or 12, further comprising:

- performing a second full-wave rectification of the discrete-time signal by a second full-wave rectifier to obtain a full-wave rectified quadrature signal, and
- performing a second digitizing of the full-wave rectified quadrature signal by a second oversampling ADC to obtain digital quadrature signal data, or
- obtaining samples of the full-wave rectified quadrature signal by a switched capacitor stage to obtain an analog quadrature signal.

**14.** The method according to claim 13, comprising using the digital quadrature signal data or the analog quadrature signal for at least one of:

- cancelling of quadrature errors from an angular rate signal,
- electrostatic quadrature compensation, and
- monitoring functional safety capable sensor.

**15.** The method according to any one of claims 11 to 14, wherein

- the discrete-time signal is an amplitude-modulated AC voltage signal with a carrier frequency, and
- wherein the method comprises operating an output transducer of the discrete-time system for producing the discrete-time signal, and the oversampling ADC with the same sample rate, and
- wherein a ratio R between frequencies of the sample rate and the carrier frequency is any one of: 8, 6, 32, and 64.

**16.** The method according to claim 15, wherein the filter is a decimation filter, and a decimation ratio applied by the decimation filter is at least equal to the ratio R.

**17.** The method according to claim 15 or 16, wherein an oversampling ratio OSR is a ratio of digital data rate after decimation filtering by the decimation filter and the sample rate, and a ratio OSR/R is $2^X$ where x is an integer at least -1, preferably at least 0, and most preferably at least 1.

**18.** The method according to any one of claims 11 to 17, wherein the discrete-time system is a sense resonator of a vibratory MEMS gyroscope with the output transducer, and the discrete-time signal represents a position of a sense mass of the sense resonator in an open sense loop of the vibratory MEMS gyroscope.

**19.** The method according to claim 18, comprising generating the discrete-time signal by sampling, by the output transducer, a Coriolis signal of the sense resonator of the vibratory MEMS gyroscope.

**20.** The method according to claim 18 or 19, wherein the discrete-time signal represents the position of the sense mass of the sense resonator in a closed force feedback loop of the vibratory MEMS gyroscope, wherein the method comprises:

- generating, by a force feedback circuitry, a force feedback signal based on the discrete-time signal.

Figure 1A

Figure 1B

Figure 2

CK_DEMOD

CK_DT

Figure 3

Figure 4A

Figure 4B

Figure 4C

Figure 5

CK_DEMOD

CK_DT

10
20
12
ck x
ck
ck x
ck x
ck
22
14
ADC
24

DT system

32
ck x
32
ck

12
ck
ck x
ck x
ck

Figure 6

1. sampling      2. sampling

$1/f_{CK\,DT}$

CK_DT (sampling phase)

CK_DEMOD (early)

CK_DEMOD (late)

Figure 7A

1. sampling      2. sampling

$1/f_{CK\,DQ}$

CK_CQ (sampling phase)

CK_DEMOD_CQ (early)

CK_DEMOD_CQ (late)

Figure 7B

Figure 8

Figure 9

Europäisches
Patentamt

European
Patent Office

Office européen
des brevets

**EUROPEAN SEARCH REPORT**

**Application Number**

EP 24 21 0119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/054475 A1 (SAWADA MASAKATSU [JP] ET AL) 26 February 2015 (2015-02-26) | 1,11 | INV. G01C19/5776 H03M3/00 |
| Y | * paragraph [0043] * | 2,5-7, 12,15-17 | |
| | ----- | | |
| X | JP H09 261967 A (SHARP KK) 3 October 1997 (1997-10-03) | 1,11 | |
| Y | * paragraphs [0023], [0027] * | 2,5-7, 12,15-17 | |
| | ----- | | |
| X | JP 7 353002 B1 (SO BRAIN CO LTD) 29 September 2023 (2023-09-29) | 1,11 | |
| Y | * paragraphs [0052], [0075], [0090], [0105] * | 2,5-7, 12,15-17 | |
| E | & EP 4 481 419 A1 (SO BRAIN CO LTD [JP]) 25 December 2024 (2024-12-25) * paragraphs [0052], [0075], [0090], [0105] * | 1,2,11, 12 | |
| | ----- | | |
| Y | CASTRO-LÃ3PEZ R ET AL: "Systematic top-down design of reconfigurable [Sigma][Delta] modulators for multi-standard transceivers", ANALOG INTEGRATED CIRCUITS AND SIGNAL PROCESSING, KLUWER ACADEMIC PUBLISHERS, BO, vol. 58, no. 3, 29 February 2008 (2008-02-29), pages 227-241, XP019668972, ISSN: 1573-1979 * the whole document * | 2,12 | **TECHNICAL FIELDS SEARCHED (IPC)** H02M G01R H03M G01C |
| | ----- | | |
| | -/-- | | |

The present search report has been drawn up for all claims

| Place of search | Date of completion of the search | Examiner |
|---|---|---|
| The Hague | 26 May 2025 | Pascheka, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 21 0119

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | RAO SUNIL SATISH ET AL: "Body biasing for analog design: Practical experiences in 22 nm FD-SOI", 2017 IEEE 20TH INTERNATIONAL SYMPOSIUM ON DESIGN AND DIAGNOSTICS OF ELECTRONIC CIRCUITS & SYSTEMS (DDECS), IEEE, 19 April 2017 (2017-04-19), pages 73-78, XP033100140, DOI: 10.1109/DDECS.2017.7934580 [retrieved on 2017-05-26] * the whole document * ----- | 2,12 | |
| Y | FREEMAN S R ET AL: "An ultrasound beamformer using oversampling", ULTRASONICS SYMPOSIUM, 1997. PROCEEDINGS., 1997 IEEE TORONTO, ONT., CANADA 5-8 OCT. 1997, NEW YORK, NY, USA,IEEE, US, vol. 2, 5 October 1997 (1997-10-05), pages 1687-1690, XP010271621, DOI: 10.1109/ULTSYM.1997.663335 ISBN: 978-0-7803-4153-1 * the whole document * ----- | 5-7, 15-17 | |
| Y | US 2020/051576 A1 (FUKUI TAKAO [JP]) 13 February 2020 (2020-02-13) * paragraph [0065] * ----- | 5-7, 15-17 | **TECHNICAL FIELDS SEARCHED (IPC)** |
| Y | US 2013/199294 A1 (TOWNSEND KEVIN [GB] ET AL) 8 August 2013 (2013-08-08) * paragraph [0022] * ----- | 5-7, 15-17 | |

The present search report has been drawn up for all claims

| Place of search | Date of completion of the search | Examiner |
|---|---|---|
| The Hague | 26 May 2025 | Pascheka, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

**EP 24 21 0119**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1, 2, 5-7, 11, 12, 15-17

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

Application Number

EP 24 21 0119

The Search Division considers that the present European patent application does not comply with the requirements of unity of invention and relates to several inventions or groups of inventions, namely:

```
1. claims: 1, 2, 11, 12

        oversampling ADC with full-wave rectifier, delta-sigma
        modulator and filter
        + a high-pass filter with a switched capacitor feedback
                            ---

2. claims: 3, 4, 13, 14

        oversampling ADC with full-wave rectifier, delta-sigma
        modulator and filter
        + a second full-wave rectifier and quadrature circuitry;
                            ---

3. claims: 5-7, 15-17

        oversampling ADC with full-wave rectifier, delta-sigma
        modulator and filter
        + defined ratio between sampling rate and carrier frequency;
                            ---

4. claims: 8-10, 18-20

        oversampling ADC with full-wave rectifier, delta-sigma
        modulator and filter
        + discrete-time system being a sense resonator of a
        vibratory MEMS gyroscope.
                            ---
```

## ANNEX TO THE EUROPEAN SEARCH REPORT
## ON EUROPEAN PATENT APPLICATION NO.

EP 24 21 0119

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2025

| Patent document cited in search report | | | Publication date | Patent family member(s) | | Publication date |
|---|---|---|---|---|---|---|
| US 2015054475 | A1 | | 26-02-2015 | CN | 103454479 A | 18-12-2013 |
| | | | | DE | 102013008882 A1 | 28-11-2013 |
| | | | | JP | 5228128 B1 | 03-07-2013 |
| | | | | JP | 2013246105 A | 09-12-2013 |
| | | | | KR | 20130133138 A | 06-12-2013 |
| | | | | TW | 201346274 A | 16-11-2013 |
| | | | | US | 2015054475 A1 | 26-02-2015 |
| JP H09261967 | A | | 03-10-1997 | JP | 3108626 B2 | 13-11-2000 |
| | | | | JP | H09261967 A | 03-10-1997 |
| JP 7353002 | B1 | | 29-09-2023 | EP | 4481419 A1 | 25-12-2024 |
| | | | | JP | 7353002 B1 | 29-09-2023 |
| | | | | JP | 7394506 B1 | 08-12-2023 |
| | | | | JP | 7465034 B1 | 10-04-2024 |
| | | | | JP | 7503876 B1 | 21-06-2024 |
| | | | | JP | 7527078 B1 | 02-08-2024 |
| | | | | JP | 2024161664 A | 20-11-2024 |
| | | | | JP | 2024161872 A | 20-11-2024 |
| | | | | JP | 2024161877 A | 20-11-2024 |
| | | | | JP | 2024161887 A | 20-11-2024 |
| | | | | JP | 2024161921 A | 20-11-2024 |
| | | | | KR | 20240163600 A | 19-11-2024 |
| | | | | TW | 202445167 A | 16-11-2024 |
| | | | | TW | 202445168 A | 16-11-2024 |
| | | | | WO | 2024232310 A1 | 14-11-2024 |
| US 2020051576 | A1 | | 13-02-2020 | EP | 3618312 A1 | 04-03-2020 |
| | | | | JP | 7099447 B2 | 12-07-2022 |
| | | | | JP | WO2018198788 A1 | 05-03-2020 |
| | | | | US | 2020051576 A1 | 13-02-2020 |
| | | | | WO | 2018198788 A1 | 01-11-2018 |
| US 2013199294 | A1 | | 08-08-2013 | CN | 102947673 A | 27-02-2013 |
| | | | | EP | 2572163 A1 | 27-03-2013 |
| | | | | JP | 5922102 B2 | 24-05-2016 |
| | | | | JP | 2013527455 A | 27-06-2013 |
| | | | | KR | 20130072224 A | 01-07-2013 |
| | | | | US | 2013199294 A1 | 08-08-2013 |
| | | | | WO | 2011144890 A1 | 24-11-2011 |

# EP 4 737 851 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **M. SAUKOSKI** ; **L. AALTONEN** ; **K. HALONEN** ; **T. SALO**. Fully integrated charge sensitive amplifier for readout of micromechanical capacitive sensors. *IEEE International Symposium on Circuits and Systems (ISCAS).*, 2005